# EUROPEAN PATENT APPLICATION

(11) **EP 4 242 169 A1**
(43) Date of publication of application: **13.09.2023**
(21) Application number: 21906124.9
(22) Date of filing: 13.10.2021
(51) Int. Cl.: B81B 3/00, B81C 1/00, H02N 1/00

(54) **VIBRATION-POWERED GENERATION ELEMENT AND METHOD FOR MANUFACTURING SAME**

(30) Priority: 17.12.2020 JP 2020209683
(71) Applicant: Saginomiya Seisakusho, Inc., Tokyo 165-0033 (JP)
(72) Inventor: SHIMOMURA, Noriko, Sayama-shi, Saitama 350-1395 (JP); ASHIZAWA, Hisayuki, Sayama-shi, Saitama 350-1395 (JP)
(74) Representative: Bandpay & Greuter
(86) International application number: PCT/JP2021/037969
(87) International publication number: WO 2022/130760

(57) **Abstract**

A great force is prevented from acting on an elastic support section of a MEMS vibration-driven energy harvesting element. A vibration-driven energy harvesting element has a fixed electrode fixed to a base section, a movable electrode movable relative to the fixed electrode, an elastic support section which has one end connected to the base section and the other end connected to the movable electrode and elastically supports the movable electrode, and at least one of a first member which is fixed to the movable electrode and faces the base section or a member fixed to the base section at a distance in a direction orthogonal to a vibration plane on which the movable electrode vibrates, and a second member which is fixed to the base section and faces the movable electrode or a member fixed to the movable electrode at a distance in a direction orthogonal to the vibration plane.

## Description

### Technical Field

The present invention relates to a vibration-driven energy harvesting element and a method for manufacturing the same.

### Background Art

As one of energy harvesting techniques for harvesting energy from ambient vibration, there is known a method for generating power from ambient vibration by the use of a vibration-driven energy harvesting element, which is a MEMS (micro electro mechanical systems) vibration-driven element.

In the vibration-driven energy harvesting element, a movable electrode is supported by an elastic support section such as a cantilever and the movable electrode vibrates relative to a fixed electrode, whereby power is generated (see PTL 1).

### Citation List

### Patent Literature

PTL 1: Japanese Patent Laid-Open No. 2020-114150

### Summary of Invention

### Technical Problem

In a conventional vibration-driven energy harvesting element, there has been a problem that, for example, if it is subjected to a great impact by being dropped on a floor surface, there is a possibility that a great force acts on the elastic support section supporting the movable electrode.

### Solution to Problem

A vibration-driven energy harvesting element according to a first aspect of the present invention comprises: a fixed electrode fixed to a base section; a movable electrode movable relative to the fixed electrode; an elastic support section which has one end connected to the base section and the other end connected to the movable electrode and elastically supports the movable electrode; and at least one of a first member which is fixed to the movable electrode and faces the base section or a member fixed to the base section at a distance in a direction orthogonal to a vibration plane on which the movable electrode vibrates, and a second member which is fixed to the base section and faces the movable electrode or a member fixed to the movable electrode at a distance in a direction orthogonal to the vibration plane.

A method for manufacturing a vibration-driven energy harvesting element according to a second aspect of the present invention is a method for manufacturing a vibration-driven energy harvesting element comprising: a fixed electrode fixed to a base section; a movable electrode movable relative to the fixed electrode; an elastic support section which has one end connected to the base section and the other end connected to the movable electrode and elastically supports the movable electrode; and at least one of a first member which is fixed to the movable electrode and faces the base section at a distance in a direction orthogonal to a vibration plane on which the movable electrode vibrates, and a second member which is fixed to the base section and faces the movable electrode at a distance in a direction orthogonal to the vibration plane, and the method comprises: a first step of preparing a substrate in which a first layer, a second layer, and a third layer are provided; a second step of etching a part of the first layer from a first layer side of the substrate and forming the fixed electrode, the movable electrode, the elastic support section, and the second member; a third step of etching a part of the third layer from a third layer side of the substrate and forming the base section and the first member; and a fourth step of etching a part of the second layer after finish of the second step and the third step and performing at least one of separation of the first member and the second member and separation of the movable electrode and the base section.

### Advantageous Effects of Invention

According to the present invention, when an impact is imposed on a MEMS vibration-driven energy harvesting element, a great force can be prevented from acting on an elastic support section.

### Brief Description of Drawings

[FIG. 1] FIG. 1 is a plan view illustrating an example of a vibration-driven energy harvesting element.
[FIG. 2] FIG. 2(a) is an enlarged view of a vicinity surrounded by a dashed line Q1 in FIG. 1, FIG. 2(b) is a schematic view showing section A-A in FIG. 2(a) from a negative Y direction to a positive direction, and FIG. 2(c) is a schematic view showing section B-B in FIG. 2(a) from the negative Y direction to the positive direction.
[FIG. 3] FIG. 3 is a flowchart illustrating a procedure for manufacturing the vibration-driven energy harvesting element.
[FIG. 4A] FIG. 4A is a schematic view showing a product in a manufacturing process.
[FIG. 4B] FIG. 4B is a schematic view showing a product in a manufacturing process.
[FIG. 4C] FIG. 4C is a schematic view showing a product in a manufacturing process.
[FIG. 4D] FIG. 4D is a schematic view showing a product in a manufacturing process.
[FIG. 5] FIG. 5 is a plan view illustrating a modified example of the vibration-driven energy harvesting element.
[FIG. 6] FIG. 6 (a) is an enlarged view of a vicinity surrounded by a dashed line Q2 in FIG. 5, FIG. 6(b) is a schematic view showing section A-A in FIG. 6(a) from a positive X direction to a negative direction, and FIG. 6(c) is a schematic view showing section B-B in FIG. 6(a) from the positive X direction to the negative direction.

### Description of Embodiments

### (Embodiment)

An embodiment of the present invention will be hereinafter described with reference to the drawings.

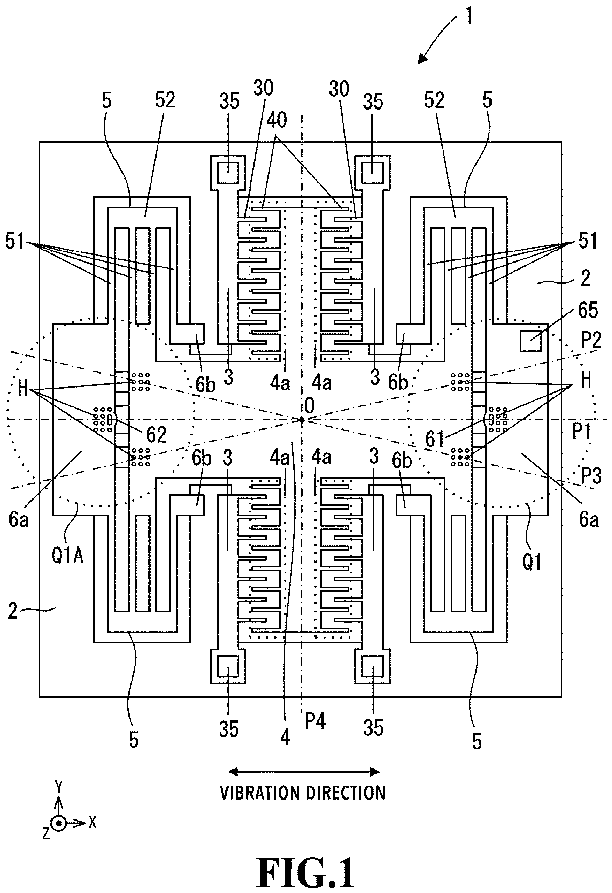

FIG. 1 is a plan view illustrating an example of a vibration-driven energy harvesting element 1. In FIG. 1 and some of the subsequent drawings, directions of an X direction, Y direction, and Z direction are expressed by a right-handed orthogonal coordinate system called a Cartesian coordinate system. The X direction, Y direction, and Z direction are directions orthogonal to one another, the X direction and Y direction are directions parallel to a plane on which a movable electrode, which will be described later in detail, vibrates at the time of power generation, and the Z direction is a direction orthogonal to the above vibrating plane.

The vibration-driven energy harvesting element 1 is made of Si and formed by, for example, a common MEMS processing technique using a SOI (silicon on insulator) substrate. The vibration-driven energy harvesting element 1 of the present embodiment is a minute energy harvesting element with a side of about ten to several tens of mm. Such a energy harvesting element generates power from, for example, mechanical vibration (ambient vibration) of a compressor or the like in operation in a factory and is used for the purpose of supplying power to a sensor, wireless terminal, and the like for monitoring.

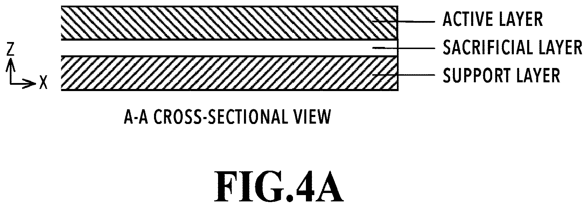

As will be described later with reference to FIG. 4A, a SOI substrate used in the present embodiment is a substrate having a triple-layer structure in which an Si support layer as a lower layer, an SiO2 sacrificial layer as a middle layer, and an Si active layer as an upper layer are stacked in the Z direction.

Incidentally, the vibration-driven energy harvesting element 1 is not limited to the SOI substrate and may be formed by using an Si substrate or the like.

In FIG. 1, the vibration-driven energy harvesting element 1 comprises a base section 2, four fixed electrodes 3 fixed on the base section 2, a movable electrode 4 provided to correspond to the fixed electrodes 3, four elastic support sections 5 elastically supporting the movable electrode 4, and two fixed sections 6a fixed on the base section 2 and supporting the four elastic support sections 5. In FIG. 1, a support layer of the SOI substrate is provided in the lower layer and the base section 2 is formed in the support layer. The four fixed electrodes 3, movable electrode 4, four elastic support sections 5, and two fixed sections 6a are all formed in an active layer in the upper layer.

The movable electrode 4 is connected to the two fixed sections 6a at both left and right ends as shown via the four elastic support sections 5. Each fixed electrode 3 is equipped with an electrode pad 35 and the fixed section 6a at the right end side as shown is also equipped with an electrode pad 65.

### (Fixed electrode and movable electrode)

Each of the four fixed electrodes 3 has a comb tooth array in which a plurality of fixed comb teeth 30 extending in the X direction are arrayed in the Y direction. The movable electrode 4 has four movable comb tooth groups 4a corresponding to the four fixed electrodes 3. Each of the four movable comb tooth groups 4a forms a comb tooth array in which a plurality of movable comb teeth 40 extending in the X direction are arrayed in the Y direction. The plurality of fixed comb teeth 30 formed in the fixed electrode 3 and the plurality of movable comb teeth 40 of the movable comb tooth group 4a corresponding to that fixed electrode 3 are arranged such that in a stationary state (neutral state), they engage with each other with a predetermined engagement length in the X direction and with a predetermined interval in the Y direction.

### (Elastic support section)

As stated above, the four elastic support sections 5 are provided. A right end section as shown of the movable electrode 4 is supported by the two right elastic support sections 5 of the four elastic support sections 5 and a left end section as shown of the movable electrode 4 is supported by the two left elastic support sections 5 of the four elastic support sections 5.

Each elastic support section 5 comprises four MEMS elastic structures 51. The four MEMS elastic structures 51 provided in the elastic support section 5 are each connected to a connecting section 52 forming the elastic support section 5.

For example, in the case of the four MEMS elastic structures 51 provided in the elastic support section 5 at the upper left as shown, the two MEMS elastic structures 51 arranged inside have lower end sides as shown connected to the movable electrode 4 and upper end sides as shown connected to the connecting section 52.

Furthermore, the MEMS elastic structure 51 arranged at the left end of the four MEMS elastic structures 51 has a lower end side as shown connected to the fixed section 6a at the left end side as shown provided on the base section 2 and an upper end side as shown connected to the connecting section 52.

Moreover, the MEMS elastic structure 51 arranged at the right end of the four MEMS elastic structures 51 has a lower end side as shown connected to a fixed section 6b at the upper left as shown provided on the base section 2 and an upper end side as shown connected to the connecting section 52.

The elastic support section 5 comprising the four MEMS elastic structures 51 connected in this manner functions as a spring. That is, the movable electrode 4 supported via the elastic support section 5 is displaced in the X direction relative to the connecting section 52 connected by the two MEMS elastic structures 51 provided inside of the four MEMS elastic structures 51, whereas the connecting section 52 is displaced in the X direction relative to the base section 2 connected by the two MEMS elastic structures 51 at both the left and right ends as shown of the four MEMS elastic structures 51.

Four MEMS elastic structures 51 provided in each of the elastic support sections 5 at the upper right, lower left, and lower right as shown also have a connection structure similar to that of the four MEMS elastic structures 51 provided in the above elastic support section 5 at the upper left as shown.

An electret is formed in at least one of the fixed teeth 30 and the movable teeth 40, and vibration of the movable electrode 4 changes the engagement length of the fixed teeth 30 and the movable teeth 40 and generates power.

Incidentally, an electret may be formed in each of the fixed teeth 30 and the movable teeth 40. Further, the movable electrode 4 described herein indicates a member which is supported by the elastic support sections 5 and vibrates in a vibration direction (X direction) integrally with the movable teeth 40 by deformation of the elastic support sections 5.

The movable electrode 4 and the base section 2 form a spring-mass resonant system by the elastic support sections 5 which function as springs as stated above. If vibration from the outside is applied to the vibration-driven energy harvesting element 1, resonance (in the case of sinusoidal vibration) or a transient response (in the case of impulse vibration) deforms the MEMS elastic structures 51 of each elastic support section 5 and vibrates the movable electrode 4 in the X direction. If the movable teeth 40 vibrate relative to the fixed teeth 30, an induced current is generated and this is extracted from the electrode pads 35 and 65 to the outside and is thereby used as a energy harvesting element.

In the vibration-driven energy harvesting element 1 described above, in a case where the vibration-driven energy harvesting element 1 is subjected to an impact (for example, about 100G) greater than normal ambient vibration, such as a case where the vibration-driven energy harvesting element 1 drops on a floor surface, there is a possibility that an unexpected great force is imposed on the elastic support sections 5. Therefore, in the present embodiment, a protection mechanism as described below is provided.

### (Stopper in the X direction)

In the vibration-driven energy harvesting element 1 as shown, the vibration direction in which the movable electrode 4 vibrates at the time of power generation is the X direction. In the present embodiment, a convex section 61 is provided by causing a part of the active layer forming the fixed section 6a at the right end side as shown to protrude in the negative X direction and, when the movable electrode 4 tries to move largely in the positive X direction, the convex section 61 is brought into contact with the right end section as shown of the movable electrode 4 and equipped with the function of a stopper which stops the movement of the movable electrode 4. If the movable electrode 4 contacts the convex section 61, since the movable electrode 4 does not move anymore in the positive X direction, an unexpected great force can be prevented from being imposed on the elastic support sections 5.

Further, a convex section 62 is provided by causing a part of the active layer forming the fixed section 6a at the left end side as shown to protrude in the positive X direction and, when the movable electrode 4 tries to move largely in the negative X direction, the convex section 62 is brought into contact with the left end section as shown of the movable electrode 4 and equipped with the function of a stopper which stops the movement of the movable electrode 4. If the movable electrode 4 contacts the convex section 62, since the movable electrode 4 does not move anymore in the negative X direction, an unexpected great force can be prevented from being imposed on the elastic support sections 5.

As explained above, in the present embodiment, a stopper in the X direction is formed by the convex section 61 and the convex section 62. The convex section 61 and the convex section 62 are provided on a straight line P1 passing through a center of gravity O of the movable electrode 4 and parallel to an X axis.

Incidentally, the elastic support section 5 comprising the MEMS elastic structures 51 described above has a spring constant in the Y direction sufficiently greater than a spring constant in the X direction. In other words, as to the Y direction orthogonal to the vibration direction (X direction) on the plane on which the movable electrode 4 vibrates at the time of power generation, the movable electrode 4 is suppressed from moving largely in the positive Y direction or the negative Y direction by making the elastic support section 5 sufficiently rigid.

### (Stopper in the Z direction)

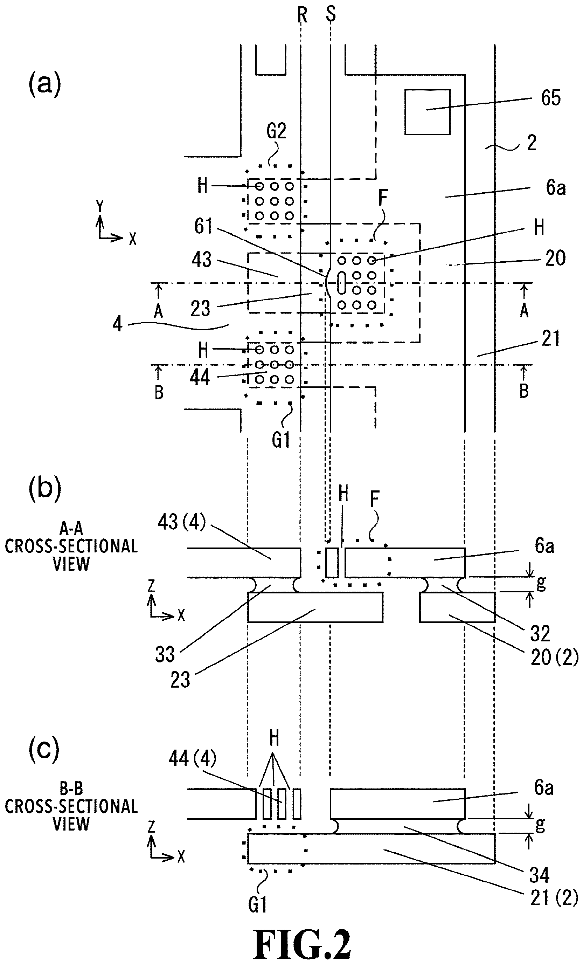

Next, a description will be given of a stopper in the Z direction orthogonal to the plane on which the movable electrode 4 vibrates at the time of power generation. FIG. 2(a) is an enlarged view of a vicinity surrounded by a dashed line Q1 in FIG. 1. FIG. 2(b) is a schematic view showing section A-A in FIG. 2(a) from the negative Y direction to the positive direction and FIG. 2(c) is a schematic view showing section B-B in FIG. 2(a) from the negative Y direction to the positive direction.

In the present embodiment, a stopper in the Z direction is formed by a first stopper and a second stopper explained below. A dash-dotted line A-A is a straight line passing through the first stopper and parallel to the X axis. Further, a dash-dotted line B-B is a straight line passing through the second stopper and parallel to the X axis.

### (First stopper)

In FIG. 2(a) and FIG. 2(b), the first stopper corresponds to an F section surrounded by a dashed line in the fixed section 6a formed in the active layer and an additional section 23 formed in the support layer to face the F section of the fixed section 6a in the Z direction, and has the function of restricting the movement of the movable electrode 4 when the movable electrode 4 tries to move largely in the positive Z direction.

Of the movable electrode 4, a region 43 overlapping the additional section 23 in a top view is mechanically fixed to the additional section 23 via a sacrificial layer 33 from the negative Z direction. A right end as shown of the additional section 23 extends in the positive X direction across a left end S as shown of the fixed section 6a.

On the other hand, the fixed section 6a formed in the active layer is mechanically fixed to a region 20 overlapping the fixed section 6a in a top view of the base section 2 formed in the support layer via a sacrificial layer 32 from the negative Z direction.

Because of such a configuration, a part of the additional section 23 connected to the movable electrode 4 overlaps the fixed section 6a mechanically fixed to the base section 2 in the F section in a top view. The fixed section 6a and the additional section 23 face each other with an interval of a gap g in the Z direction in a stationary state (neutral state). The gap g is about 1 to 5 µm and is equivalent to the thickness of the sacrificial layer.

Incidentally, the F section of the fixed section 6a is provided with a plurality of holes H for etching penetrating the fixed section 6a in the Z direction. The holes H are also referred to as release holes. The number and shape of the release holes do not have to be a number as shown and a circular shape and the shape may be an elliptical shape or a rectangular shape.

When the movable electrode 4 (region 43) moves the distance g in the positive Z direction and the additional section 23 connected to the movable electrode 4 contacts the fixed section 6a in the F section, since the movable electrode 4 (region 43) does not move anymore in the positive Z direction, an unexpected great force is prevented from being imposed on the elastic support sections 5 elastically supporting the movable electrode 4.

The first stopper described above is positioned on the straight line P1 passing through the center of gravity O of the movable electrode 4 and parallel to the X axis. That is, the dash-dotted line A-A in FIG. 2(a) corresponds to the straight line P 1.

### (Second stopper)

In FIG. 2(a) and FIG. 2(c), the second stopper corresponds to a G1 section surrounded by a dashed line of the base section 2 formed in the support layer and a region 44 facing the G1 section in the Z direction of the movable electrode 4 formed in the active layer, and has the function of restricting the movement of the movable electrode 4 when the movable electrode 4 tries to move largely in the negative Z direction.

A region 21 of the base section 2 extends in the negative X direction across a right end R as shown of the movable electrode 4. Because of such a configuration, the region 21 of the base section 2 overlaps the region 44 of the movable electrode 4 in the G1 section in a top view. The region 44 of the movable electrode 4 and the region 21 of the base section 2 face each other with an interval of a gap g in the Z direction in a stationary state (neutral state). As stated above, the gap g is equivalent to the thickness of the sacrificial layer.

Incidentally, the region 44 of the movable electrode 4 is provided with a plurality of holes H (release holes) for etching penetrating the movable electrode 4 in the Z direction. The number and shape of the release holes do not have to be a number as shown and a circular shape and the shape may be an elliptical shape or a rectangular shape.

When the movable electrode 4 (region 44) moves the distance g in the negative Z direction and the movable electrode 4 contacts the region 21 of the base section 2 in the G1 section, since the movable electrode 4 (region 44) does not move anymore in the negative Z direction, an unexpected great force is prevented from being imposed on the elastic support sections 5 elastically supporting the movable electrode 4.

The second stopper described above is provided at two positions having a symmetric relationship with respect to the dash-dotted line A-A in FIG. 2(a). That is, a G2 section at a position symmetric to the explained G1 section with respect to the line A-A is also provided with a second stopper similar to that of the G1 section.

Further, stoppers similar to the first stopper and second stopper stated above are also provided at positions shown within a dashed line Q1A having a symmetric relationship to the positions shown within the dashed line Q1 with respect to a straight line P4 passing through the center of gravity O of the movable electrode 4 and parallel to an Y axis. That is, the second stopper stated above is provided at two left and right positions on a straight line P2 passing through the center of gravity O of the movable electrode 4 and also provided at two left and right positions on a straight line P3 passing through the center of gravity O of the movable electrode 4.

### (Method for manufacturing the vibration-driven energy harvesting element)

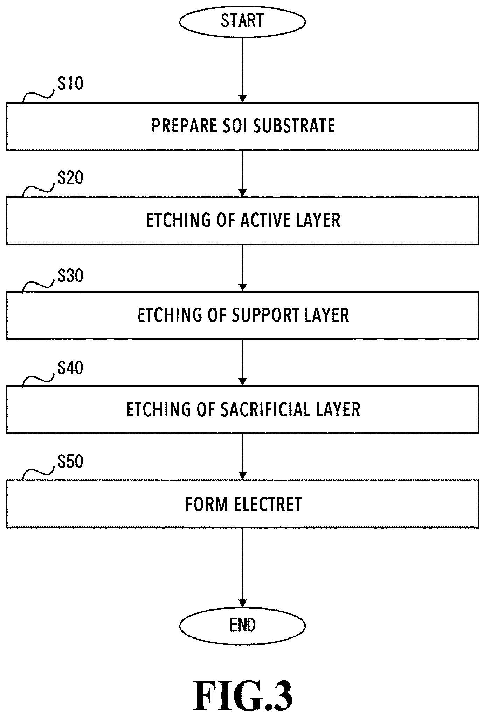

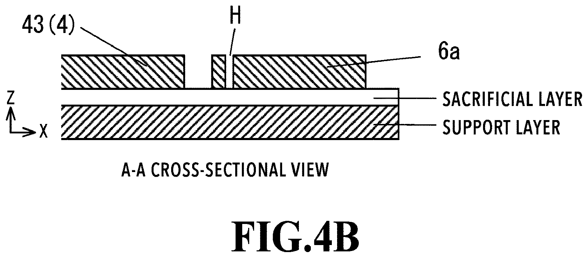

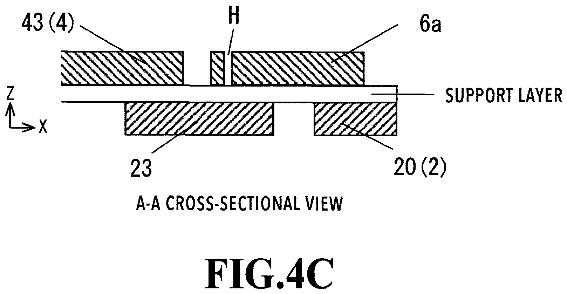

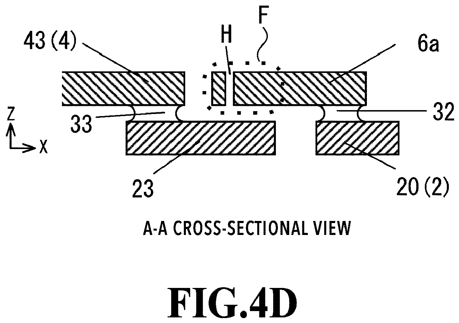

An example of a method for manufacturing the vibration-driven energy harvesting element 1 will be described below with reference to FIG. 3 and FIG. 4. FIG. 3 is a flowchart illustrating a procedure for manufacturing the vibration-driven energy harvesting element 1. FIG. 4A to FIG. 4D are schematic views showing a product in a manufacturing process. FIG. 4A to FIG. 4D each correspond to a range illustrated in the A-A cross-sectional view of FIG. 2(b) and the cross sections of the active layer and support layer are hatched to facilitate understanding.

### (Process 1)

In step S10 of FIG. 3, a worker or a manufacturing apparatus prepares a SOI substrate shown in FIG. 4A.

### (Process 2)

In step S20 of FIG. 3, the worker or manufacturing apparatus etches the active layer, which is the upper layer of the SOI substrate, by RIE (reactive ion etching) using a gas including fluorine such as SF6 or CF4 in order to form a pattern of the movable electrode 4, the fixed section 6a, and the like in a range shown in FIG. 4B and also form a pattern of the fixed electrodes 3, the movable electrode 4, the elastic support sections 5, the fixed section 6a, and the like in a range not shown in FIG. 4B.

More specifically, after a resist not shown is formed on the entire surface of the active layer, the resist is partially removed to form an aperture section. The aperture section includes apertures for the holes H (release holes) for etching. The resist is removed by, for example, a photolithographic process including light exposure, development, and the like.

The active layer is then etched by using the resist left behind as an etching mask, thereby forming a pattern penetrating the active layer in the Z direction as shown in FIG. 4B. After that, the remaining resist and the like are removed by SPM (sulfuric acid peroxide mixture) cleaning.

Incidentally, although the present embodiment describes an example of adopting dry etching into process 2, wet etching may be adopted into process 2.

### (Process 3)

In step S30, the worker or manufacturing apparatus etches the support layer, which is the lower layer of the SOI substrate, by RIE as in the case of step S20 in order to form a pattern of the region 20, the additional section 23, and the like of the base section 2 in a range shown in FIG. 4C and also form a pattern of the region 21 and the like of the base section 2 in a range not shown in FIG. 4C.

More specifically, after a resist not shown is formed on the entire surface of the support layer, the resist is partially removed to form an aperture section. The resist is removed by a photolithographic process as in the case of the active layer.

The support layer is then etched by using the resist left behind as an etching mask, thereby forming a pattern penetrating the support layer in the Z direction as shown in FIG. 4C. After that, the remaining resist and the like are removed by SPM cleaning.

Incidentally, although the present embodiment describes an example of adopting dry etching into process 3, wet etching may be adopted into process 3.

### (Process 4)

In step S40, the worker or manufacturing apparatus removes the sacrificial layer, which is the middle layer of the SOI substrate, by wet etching using BHF (buffered hydrofluoric acid). The sacrificial layer in regions in which at least one of the upper side (active layer side) and the lower side (support layer side) of the sacrificial layer is exposed through process 2 and process 3 stated above is etched by the BHF, and the active layer alone or the support layer alone is left behind as shown in FIG. 4D. After process 2 and process 3 stated above, the sacrificial layer in regions in which neither the upper side (active layer side) nor the lower side (support layer side) is exposed is left behind even after wet etching and keeps mechanically fixing the active layer to the support layer (sacrificial layer 32, 33, and 34).

Here, even if neither of the upper side (active layer side) and lower side (support layer side) of the sacrificial layer is exposed after process 2 and process 3, the sacrificial layer corresponding to a region in which the hole H (release hole) for etching is provided in the active layer as the upper layer is etched through the release hole. In the present embodiment, the sacrificial layer corresponding to the F section and the sacrificial layer corresponding to the G1 section and the G2 section in the range not shown are etched through the release holes. By this etching method, a region corresponding to the F section of the fixed section 6a is separated from the additional section 23 extending in the positive X direction and the movable electrode 4 corresponding to the G1 section and the G2 section in the range not shown is separated from the region 21 of the base section 2 and the like extending in the negative X direction.

Incidentally, although the present embodiment describes an example of adopting wet etching into process 4, dry etching may be adopted into process 4.

### (Process 5)

Through the procedure illustrated in process 1 to process 4 above, a MEMS processed body of the vibration-driven energy harvesting element 1 in which an electret is not yet formed is formed. In step S50 as process 5, the worker or manufacturing apparatus forms an electret in the fixed electrode 3 and/or the movable electrode 4 by a publicly-known electret formation process (for example, a formation process disclosed in Japanese Patent Laid-Open No. 2014-50196).

The vibration-driven energy harvesting element 1 is manufactured through process 1 to process 5 explained above.

According to the embodiment described above, the following advantageous effects can be obtained. (1) The vibration-driven energy harvesting element 1 comprises the fixed electrode 3 fixed to the base section 2, the movable electrode 4 movable relative to the fixed electrode 3, the elastic support section 5 which has one end connected to the base section 2 and the other end connected to the movable electrode 4 and elastically supports the movable electrode 4, the additional section 23 forming the first stopper as a first member fixed to the movable electrode 4 and facing the fixed section 6a fixed to the base section 2 at a distance in the Z direction orthogonal to the vibration plane (XY plane) on which the movable electrode 4 vibrates, and the fixed section 6a forming the first stopper as a second member fixed to the base section 2 and facing the additional section 23 fixed to the movable electrode 4 at a distance in the Z direction.

Because of such a configuration, for example, when the movable electrode 4 tries to move largely in the positive Z direction, the additional section 23 fixed to the movable electrode 4 contacts the fixed section 6a (F section) fixed to the base section 2 and restricts the movement of the movable electrode 4. This prevents an unexpected great force from being imposed on the elastic support section 5 elastically supporting the movable electrode 4.

(2) The vibration-driven energy harvesting element 1 of (1) above comprises the region 21 of the base section 2 forming the second stopper as a second member extending from the base section 2 and facing the movable electrode 4 at a distance in the Z direction. Because of such a configuration, for example, when the movable electrode 4 tries to move largely in the negative Z direction, the region 21 (G1 section) extending from the base section 2 contacts the region 44 of the movable electrode 4 and restricts the movement of the movable electrode 4. This prevents an unexpected great force from being imposed on the elastic support section 5 elastically supporting the movable electrode 4.

(3) In the vibration-driven energy harvesting element 1 of (1) above, since the additional section 23 as the first member and the fixed section 6a as the second member face each other at a distance in the Z direction in the F section, the movable electrode 4 can be prevented from moving more than the gap g between the additional section 23 and the fixed section 6a.

(4) In the vibration-driven energy harvesting element 1 of (2) above, the region 21 of the base section 2 as the second member extends from the base section 2 in the negative X direction parallel to the vibration plane (XY plane) toward the movable electrode 4 and faces the movable electrode 4 (region 44) at a distance in the Z direction. Because of such a configuration, the movable electrode 4 can be prevented from moving more than the gap g between the movable electrode 4 and the base section 2.

(5) In the vibration-driven energy harvesting element 1 of (1) or (3) above, the movable electrode 4, the fixed electrode 3, the elastic support section 5, and the fixed section 6a as the second member are formed in the active layer of the SOI substrate in which the active layer, the sacrificial layer, and the support layer are provided, and the base section 2 and the additional section 23 as the first member are formed in the support layer of the SOI substrate. Because of such a configuration, the first member and the second member formed in different layers at a distance can be comprised.

(6) In the vibration-driven energy harvesting element 1 of (5) above, the additional section 23 as the first member is fixed to the movable electrode 4 via the sacrificial layer and the fixed section 6a as the second member is fixed to the base section 2 via the sacrificial layer. Because of such a configuration, the additional section 23 and the fixed section 6a fixed to the movable electrode 4 and the base section 2, respectively, can be comprised.

(7) In the vibration-driven energy harvesting element 1 of (1) above, each of the additional section 23 and the fixed section 6a (F section) forming the first stopper is provided in both end sections (in the ranges shown by the dashed line Q1 and dashed line Q1A) in the vibration direction (X direction) of the movable electrode 4 on the straight line P1 passing through the center of gravity O of the movable electrode 4 in a top view. Further, each of the movable electrode 4 (region 44) and the region 21 (G1 section) of the base section 2 forming the second stopper is provided in both end sections (in the ranges shown by the dashed line Q1 and dashed line Q1A) in the vibration direction (X direction) of the movable electrode 4 on the straight lines P2 and P3 passing through the center of gravity O of the movable electrode 4 in a top view.

Because of such a configuration, since the position of the center of gravity O of the movable electrode 4 is not changed by providing the first stopper and the second stopper, the vibration property of the movable electrode 4 is not impaired.

(8) A method for manufacturing the vibration-driven energy harvesting element 1 stated above comprises a first step of preparing a SOI substrate in which the active layer as a first layer, the sacrificial layer as a second layer, and the support layer as a third layer are provided, a second step of etching a part of the active layer from the active layer side of the SOI substrate and forming the fixed electrode 3, the movable electrode 4, the elastic support section 5, and the second member, a third step of etching a part of the support layer from the support layer side of the SOI substrate and forming the base section 2 and the first member, and a fourth step of etching a part of the sacrificial layer after finish of the second step and the third step and performing at least one of separation of the first member and the second member and separation of the movable electrode 4 and the base section 2.

Because of such a configuration, the additional section 23 and the fixed section 6a (F section), which contact each other when the movable electrode 4 tries to move largely in the positive Z direction, and the movable electrode 4 (region44) and the region 21 (G1 section) of the base section 2, which contact each other when the movable electrode 4 tries to move largely in the negative Z direction, can be appropriately formed.

(9) In the method for manufacturing the vibration-driven energy harvesting element 1 of (8) above, the movable electrode 4 and the additional section 23 as the first member are integrally formed via the sacrificial layer left behind in the fourth step and the base section 2 and the fixed section 6a as the second member are integrally formed via the sacrificial layer left behind in the fourth step.

Because of such a configuration, each section can be appropriately formed.

(10) In the method for manufacturing the vibration-driven energy harvesting element 1 of (9) above, the fourth step removes the sacrificial layer in each of a region from which the active layer has been removed by the second step, a region from which the support layer has been removed by the third step, and opposing opposite regions (F section and G1 section).

Because of such a configuration, each section can be appropriately formed.

### (Modified example)

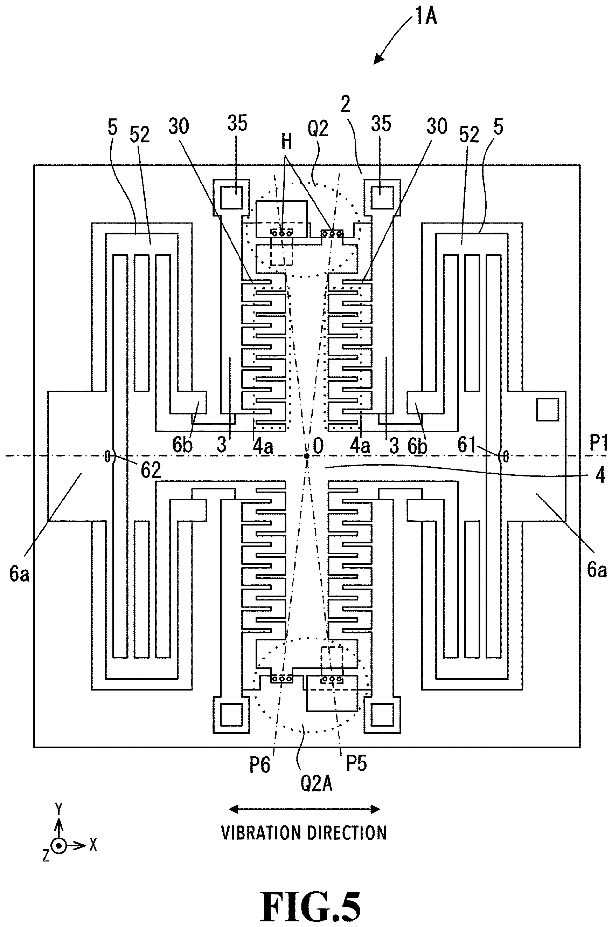

The positions to arrange the first stopper and the second stopper as stoppers in the Z direction may be arranged at positions different from the positions shown within the dashed line Q1 and the dashed line Q1A illustrated in FIG. 1. FIG. 5 is a plan view illustrating a vibration-driven energy harvesting element 1A of a modified example of the above embodiment. In FIG. 5, features similar to those of the vibration-driven energy harvesting element illustrated in FIG. 1 are expressed by the same reference numerals and the description thereof is omitted. The vibration-driven energy harvesting element 1A of FIG. 5 is different from the vibration-driven energy harvesting element 1 of FIG. 1 in that the first stopper and the second stopper are provided at positions shown within a dashed line Q2 and a dashed line Q2A instead of the positions shown within the dashed line Q1 and the dashed line Q1A. That is, in the modified example, the stoppers in the Z direction are formed by the first stopper and the second stopper described below.

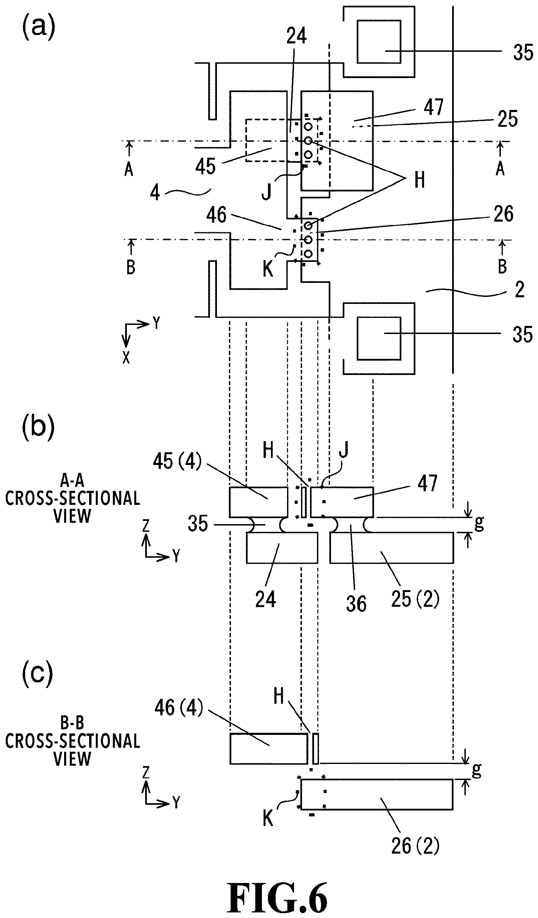

FIG. 6 (a) is an enlarged view of a vicinity surrounded by the dashed line Q2 in FIG. 5. FIG. 6(b) is a schematic view showing section A-A in FIG. 6(a) from the positive X direction to the negative direction, and FIG. 6(c) is a schematic view showing section B-B in FIG. 6(a) from the positive X direction to the negative direction. A dash-dotted line A-A is a straight line passing through the first stopper and parallel to the Y axis. Further, a dash-dotted line B-B is a straight line passing through the second stopper and parallel to the Y axis.

### (First stopper)

In FIG. 6(a) and FIG. 6(b), the first stopper corresponds to a J section surrounded by a dashed line of a first additional section 47 formed in the active layer and a second additional section 24 formed in the support layer to face the J section in the active layer in the Z direction, and has the function of restricting the movement of the movable electrode 4 when the movable electrode 4 tries to move largely in the positive Z direction.

The first additional section 47 is mechanically fixed to a region 25 overlapping the first additional section 47 in a top view of the base section 2 formed in the support layer via a sacrificial layer 36 from the negative Z direction.

On the other hand, a region 45 overlapping the second additional section 24 in a top view of the movable electrode 4 is mechanically fixed to the second additional section 24 formed in the support layer via a sacrificial layer 35 from the negative Z direction. A right end as shown of the second additional section 24 extends in the positive Y direction across a left end as shown of the first additional section 47.

Because of such a configuration, a part of the second additional section 24 connected to the movable electrode 4 overlaps the first additional section 47 mechanically fixed to the base section 2 in the J section in a top view. The first additional section 47 and the second additional section 24 face each other with an interval of a gap g in the Z direction in a stationary state (neutral state). The gap g is about 1 to 5 µm and is equivalent to the thickness of the sacrificial layer.

Incidentally, the J section of the first additional section 47 is provided with a plurality of holes H (release holes) for etching penetrating the first additional section 47 in the Z direction. The number and shape of the release holes do not have to be a number as shown and a circular shape and the shape may be an elliptical shape or a rectangular shape.

When the movable electrode 4 (region 45) moves the distance g in the positive Z direction and the second additional section 24 connected to the movable electrode 4 contacts the first additional section 47 in the J section, since the movable electrode 4 (region 45) does not move anymore in the positive Z direction, an unexpected great force is prevented from being imposed on the elastic support sections 5 elastically supporting the movable electrode 4.

### (Second stopper)

In FIG. 6(a) and FIG. 6(c), the second stopper corresponds to a K section surrounded by a dashed line of the base section 2 formed in the support layer and a region 46 facing the above K section in the Z direction of the movable electrode 4 formed in the active layer, and has the function of restricting the movement of the movable electrode 4 when the movable electrode 4 tries to move largely in the negative Z direction.

A region 26 of the base section 2 extends in the negative Y direction across a right end as shown of the above region 46 of the movable electrode 4. Further, the region 46 of the movable electrode 4 formed in the active layer extends in the positive Y direction across a left end as shown of the above region 26 of the base section 2.

Because of such a configuration, the region 46 of the movable electrode 4 overlaps the region 26 of the base section 2 in the K section in a top view. The movable electrode 4 (region 46) and the base section 2 (region 26) face each other with an interval of the gap g in the Z direction in a stationary state (neutral state). As stated above, the gap g is equivalent to the thickness of the sacrificial layer.

Incidentally, the region 46 of the active layer is provided with a plurality of holes H (release holes) for etching penetrating the active layer in the Z direction. The number and shape of the release holes do not have to be a number as shown and a circular shape and the shape may be an elliptical shape or a rectangular shape.

When the movable electrode 4 (region 46) moves the distance g in the negative Z direction and the movable electrode 4 contacts the support layer 26 in the K section, since the movable electrode 4 (region 46) does not move anymore in the negative Z direction, an unexpected great force is prevented from being imposed on the elastic support section 5 elastically supporting the movable electrode 4.

The first stopper and second stopper described above are provided at positions substantially equidistant from the straight line P4 passing through the center of gravity O of the movable electrode 4 and parallel to the Y axis. That is, the explained line A-A and line B-B are parallel to the straight line P4 and equidistant from the straight line P4 in the vibration-driven energy harvesting element 1A.

Further, stoppers similar to the first stopper and second stopper explained in the modified example are also provided at positions shown within the dashed line Q2A having a symmetric relationship to the positions shown within the dashed line Q2 with respect to the center of gravity O of the movable electrode 4. That is, the first stopper stated above is provided at two upper and lower positions on a straight line P5 passing through the center of gravity O of the movable electrode 4, and the second stopper stated above is provided at two upper and lower positions on a straight line P6 passing through the center of gravity O of the movable electrode 4.

A method for manufacturing the vibration-driven energy harvesting element 1A is similar to the method for manufacturing the vibration-driven energy harvesting element 1. Therefore, the description of the method for manufacturing the vibration-driven energy harvesting element 1A is omitted.

According to the modified example described above, advantageous effects similar to those of the above embodiment can be obtained. (1) The vibration-driven energy harvesting element 1A comprises the fixed electrode 3 fixed to the base section 2, the movable electrode 4 movable relative to the fixed electrode 3, the elastic support section 5 which has one end connected to the base section 2 and the other end connected to the movable electrode 4 and elastically supports the movable electrode 4, the additional section 24 forming the first stopper as a first member fixed to the movable electrode 4 and facing the additional section 47 fixed to the base section 2 at a distance in the Z direction orthogonal to the vibration plane (X-Y plane) on which the movable electrode 4 vibrates, and the additional section 47 forming the first stopper as a second member fixed to the base section 2 and facing the additional section 24 fixed to the movable electrode 4 at a distance in the Z direction.

Because of such a configuration, for example, when the movable electrode 4 tries to move largely in the positive Z direction, the additional section 24 fixed to the movable electrode 4 contacts the additional section 47 (J section) fixed to the base section 2 and restricts the movement of the movable electrode 4. This prevents an unexpected great force from being imposed on the elastic support section 5 elastically supporting the movable electrode 4.

(2) The vibration-driven energy harvesting element 1A of (1) above comprises the region 26 of the base section 2 forming the second stopper as a second member extending from the base section 2 and facing the movable electrode 4 at a distance in the Z direction. Because of such a configuration, for example, when the movable electrode 4 tries to move largely in the negative Z direction, the region 26 (K section) extending from the base section 2 contacts the region 46 of the movable electrode 4 and restricts the movement of the movable electrode 4. This prevents an unexpected great force from being imposed on the elastic support section 5 elastically supporting the movable electrode 4.

(3) In the vibration-driven energy harvesting element 1A of (1) above, since the additional section 24 as the first member and the additional section 47 as the second member face each other at a distance in the Z direction in the J section, the movable electrode 4 can be prevented from moving more than the gap g between the additional section 24 and the additional section 47.

(4) In the vibration-driven energy harvesting element 1A of (2) above, the region 26 of the base section 2 as the second member extends from the base section 2 in the negative Y direction parallel to the vibration plane (X-Y plane) toward the movable electrode 4 and faces the movable electrode 4 at a distance in the Z direction. Because of such a configuration, the movable electrode 4 can be prevented from moving more than the gap g between the movable electrode 4 and the base section 2.

(5) In the vibration-driven energy harvesting element 1A of (2) above, the region 46 of the movable electrode 4 as the first member extends from the movable electrode 4 in the positive Y direction parallel to the vibration plane toward the base section 2 and faces the base section 2 (region 26). Because of such a configuration, the movable electrode 4 can be prevented from moving more than the gap g between the movable electrode 4 and the base section 2.

In the embodiment described above, a substrate (SOI substrate) having an Si support layer, an SiO2 sacrificial layer, and an Si active layer is used as the substrate, but the substrate is not limited to the SOI substrate. The substrate may be any substrate in which a first layer as an active layer, a second layer as a sacrificial layer, and a third layer as a support layer are stacked and the anti-etching property of the second layer is different from the anti-etching properties of the first layer and third layer. The second layer or third layer of them may be a layer made of an insulating material.

As an example, the substrate may be one in which a second layer of SiO2 and a first layer of Si are formed on a third layer of sapphire. As another example, it may be one in which a second layer of metal oxide and a first layer of metal are formed on a third layer of metal.

Further, gases and the like used in the etching processes described above are an example and other gasses may be used.

Although various embodiments and modified examples have been described above, the present invention is not limited to the contents thereof. The numbers, shapes, and the like of various parts in the embodiments are shown as an example and may be any other numbers and shapes.

Further, the embodiments and modified examples may be each applied solely or may be used in combination.

Further, other aspects conceivable within the scope of the technical idea of the present invention are also included in the scope of the present invention.

### Reference Signs List

1, 1A vibration-driven energy harvesting element
2 base section
3 fixed electrode
4 movable electrode
5 elastic support section
6a, 6b fixed section
20, 21, 25, 26, 43, 44, 45, 46, F, G1, G2, J, K region
23, 24, 47 additional section
32, 33, 34, 35, 36 sacrificial layer

## Claims

1. A vibration-driven energy harvesting element, comprising:
a fixed electrode fixed to a base section;
a movable electrode movable relative to the fixed electrode;
an elastic support section which has one end connected to the base section and the other end connected to the movable electrode and elastically supports the movable electrode; and
at least one of a first member which is fixed to the movable electrode and faces the base section or a member fixed to the base section at a distance in a direction orthogonal to a vibration plane on which the movable electrode vibrates, and a second member which is fixed to the base section and faces the movable electrode or a member fixed to the movable electrode at a distance in a direction orthogonal to the vibration plane.

2. The vibration-driven energy harvesting element according to claim 1, wherein
at least a part of the first member and at least a part of the second member face each other at a distance in a direction orthogonal to the vibration plane.

3. The vibration-driven energy harvesting element according to claim 1, wherein
the first member extends from the movable electrode in a direction parallel to the vibration plane toward the base section and faces the base section.

4. The vibration-driven energy harvesting element according to claim 1, wherein
the second member extends from the base section in a direction parallel to the vibration plane toward the movable electrode and faces the movable electrode.

5. The vibration-driven energy harvesting element according to claim 1 or 2, wherein
the movable electrode, the fixed electrode, the elastic support section, and the second member are formed in a first layer of a substrate in which the first layer, a second layer, and a third layer are provided, and
the base section and the first member are formed in the third layer of the substrate.

6. The vibration-driven energy harvesting element according to claim 5, wherein
the first member is fixed to the movable electrode via the second layer, and
the second member is fixed to the base section via the second layer.

7. The vibration-driven energy harvesting element according to any one of claims 1 to 6, wherein
each of the first member and the second member is provided at both end sections in a vibration direction of the movable electrode on a straight line passing through a center of gravity of the movable electrode in a top view.

8. The vibration-driven energy harvesting element according to any one of claims 1 to 7, wherein
each of the first member and the second member is provided at both end sections in a direction orthogonal to a vibration direction of the movable electrode on a straight line passing through a center of gravity of the movable electrode in a top view.

9. A method for manufacturing a vibration-driven energy harvesting element, the vibration-driven energy harvesting element comprising: a fixed electrode fixed to a base section; a movable electrode movable relative to the fixed electrode; an elastic support section which has one end connected to the base section and the other end connected to the movable electrode and elastically supports the movable electrode; and at least one of a first member which is fixed to the movable electrode and faces the base section at a distance in a direction orthogonal to a vibration plane on which the movable electrode vibrates, and a second member which is fixed to the base section and faces the movable electrode at a distance in a direction orthogonal to the vibration plane,
the method comprising:
a first step of preparing a substrate in which a first layer, a second layer, and a third layer are provided;
a second step of etching a part of the first layer from a first layer side of the substrate and forming the fixed electrode, the movable electrode, the elastic support section, and the second member;
a third step of etching a part of the third layer from a third layer side of the substrate and forming the base section and the first member; and
a fourth step of etching a part of the second layer after finish of the second step and the third step and performing at least one of separation of the first member and the second member and separation of the movable electrode and the base section.

10. The method for manufacturing the vibration-driven energy harvesting element according to claim 9, wherein
the movable electrode and the first member are integrally formed via the second layer left behind in the fourth step, and
the base section and the second member are integrally formed via the second layer left behind in the fourth step.

11. The method for manufacturing the vibration-driven energy harvesting element according to claim 10, wherein
the fourth step removes the second layer in each of a region from which the first layer has been removed by the second step, a region from which the third layer has been removed by the third step, and the opposing opposite regions.
